# EUROPEAN PATENT APPLICATION

(11) **EP 1 345 324 A2**
(43) Date of publication of application: **17.09.2003**
(21) Application number: 03100624.0
(22) Date of filing: 12.03.2003
(51) Int. Cl.: H03J 3/08, H03J 5/24, H03J 1/00

(54) **Tuner**

(30) Priority: 12.03.2002 GB 2056984
(71) Applicant: Zarlink Semiconductor Limited, Swindon, Wiltshire SN2 2QW (GB)
(72) Inventor: COWLEY, Nicholas, Paul, SN4 0RT, Wroughton (GB); MUDD, Mark, Stephen, John, SN4 7SD, Swindon (GB)
(74) Representative: Robinson, John Stuart

(57) **Abstract**

A tuner is provided for converting any selected channel in an input band to zero intermediate frequency. The tuner input 1 is connected to the inputs of a plurality of input stages 2 to 4. Each input stage comprises tracking filters 6, 9 having a passband which is tunable across the tuning range of the input stage, where the tuning ranges of the stages 2 to 4 form a contiguous or overlapping set so as to provide tuning across the whole of the input band. Only one of the input stages 2 to 4 is enabled at a time with the disabled stages being depowered. A frequency changer 12, 13 converts the selected channel from the enabled input stage to substantially zero intermediate frequency.

## Description

The present invention relates to a tuner, for example for use as a digital terrestrial tuner or other multimedia digital tuner.

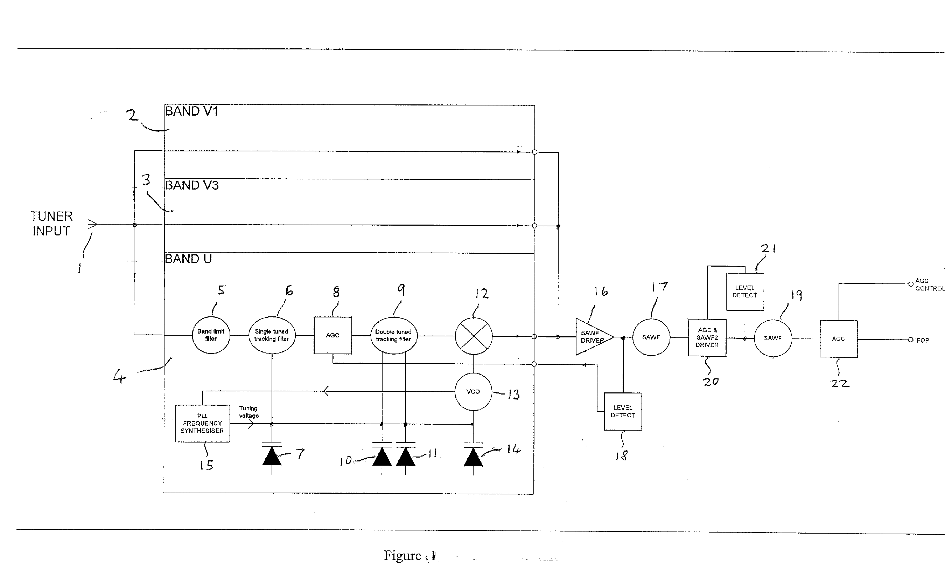

Figure 1 of the accompanying drawings illustrates a known type of digital terrestrial tuner of the single conversion superheterodyne type. The tuner has an input 1 for receiving a radio frequency signal connected to the inputs of three input stages 2, 3 and 4. The input stages are substantially identical in their structure and function so that only the input stage 4 will be described in detail. The input stages 2, 3 and 4 are used for reception of bands V1, V3 and U, respectively. The three bands covered by the input stages are contiguous or overlap with each other and in a typical example cover the range 50 to 860MHz.

The input stage 4 comprises an input band limit filter 5 which has fixed characteristics and which passes the band U while attenuating signals outside this band. The output of the filter 5 is supplied to a first tracking filter 6, which is a single tuned notch filter for suppressing the local oscillator frequency without substantially attenuating a channel which has been selected for reception. The filter includes a variable capacitance diode 7 for controlling the resonant frequency.

The output of the filter 6 is supplied to an automatic gain control (AGC) circuit 8 whose output is supplied to a second tracking filter 9. The filter 9 is a double tuned bandpass filter whose centre frequency is controlled by variable capacitance diodes 10 and 11. The filter 9 acts as an image reject tracking filter whose passband is centred substantially on the channel selected for reception and has a bandwidth sufficient to pass the selected channel.

The output of the filter 9 is supplied to a mixer 12 forming part of a frequency changer which also comprises a voltage controlled oscillator 13 tuned by a variable capacitance diode 14. The frequency of oscillation of the oscillator 13 is controlled by a phase locked loop (PLL) frequency synthesiser 15 which receives the oscillator signal and supplies a tuning voltage to the diode 14. The synthesiser 15 is controlled by a controller (not shown) such that the frequency of the oscillator 13 is substantially equal to the radio frequency of the selected channel plus the intermediate frequency (IF).

Although the synthesiser 15 has been shown within the input stage 4, in practice a single synthesiser is provided for controlling the VCOs of all of the input stages 2 to 4. The tuning voltage is also supplied to the variable capacitance diodes 7, 10 and 11 so that the filters 6 and 9 track the frequency of the VCO 13 but with their resonant frequencies appropriately offset from the VCO frequency so as to provide image rejection for each selected channel and suppression of the oscillator output so as to prevent re-radiation via the tuner input 1.

The outputs of all of the input stages 2 to 4 are connected to an amplifier 16, which amplifies the IF signal from the currently operating input stage and provides impedance matching to a surface acoustic wave filter (SAWF) 17. The filter 17 is of fixed bandpass type with its centre frequency at the intermediate frequency, which is typically 36MHz. The output of the amplifier 16 is also supplied to a level detection circuit 18, which monitors the signal amplitude at the output of the amplifier 16 and supplies a control signal to the AGC circuit 8 so as to maximise the level of the selected channel while minimising distortion from undesired interfering signals, which may be of greater amplitude than the selected channel.

The output of the filter 17 is supplied to another AGC circuit or driver 20, which amplifies the IF signal and provides impedance matching between the filter 17 and a further similar SAWF 19. The output of the driver 20 is also connected to a further level detecting circuit 21 so as to optimise the signal level at the input of the filter 19. The output of the filter 19 is supplied to another AGC circuit 22 whose output supplies the IF output signal of the tuner, for example to a digital demodulator. The demodulator (not shown) demodulates the selected channel in accordance with the modulation standard for the channel and also supplies an AGC control signal to the circuit 22 so as to optimise the signal level supplied to the demodulator.

In a typical application, the input stage 4 receives UHF signals between 470 and 860MHz so that the tuning range of the VCO 13 for an IF of 36MHz is from 506 to 896MHz. Each channel in a broadband signal supplied to the tuner input 1 has a bandwidth which is nominally 8MHz. The passband of the input stage 4 defined by the tracking filters should preferably be equal to the channel bandwidth but, in practice, is generally 2 to 3 times the channel bandwidth and varies as the filters are tuned across the band. Outside the filter passband, the attenuation provided by the filters increases with distances from the passband but, in practice, only limited attenuation of adjacent channels may be provided by the input stage filtering.

A disadvantage of this type of known tuner is that the output IF requires conversion from analog to digital before or within the following demodulator. Digitisation at the standard IF is demanding on analog/digital converter (ADC) performance. Also, this type of tuner requires the use of relatively large and expensive surface acoustic wave filters in order to provide a signal of adequate quality for correct demodulation. Although it would be desirable to implement the tuner as a single integrated circuit, surface acoustic wave filters of adequate quality cannot be implemented within monolithic integrated circuits.

Although it is theoretically possible to embody the whole of the tuner except the surface acoustic wave filters as a single integrated circuit, in practice this is difficult or impossible. In particular, difficulties are caused by the finite amount of isolation which may be achieved around an integrated circuit package. For example, the insertion loss of a typical surface acoustic wave filter is 20dB. The inter-filter amplifier 20 typically has a gain of 10dB so that the gain through the filters is -30dB. The leakage path of signals around an integrated circuit package is typically about -45dB so that the ratio of the required signal to the leakage signal is only about 15dB. The leakage signal is phase-shifted with respect to the direct signal and so appears as an interference signal which makes acceptable demodulation of the selected channel difficult or impossible.

According to the invention, there is provided a tuner for converting any selected one of a plurality of radio frequency channels to substantially zero intermediate frequency, comprising a radio frequency input connected to the inputs of a plurality of input stages, each of which comprises at least one tracking filter having a passband which is tunable across a tuning range, the tuning ranges of the input stages being different from each other and the input stages being arranged to be enabled one at a time; and a frequency changer arrangement for converting the selected channel from the enabled one of the input stages to substantially zero intermediate frequency.

The radio frequency channels may contain digitally modulated signals.

Adjacent ones of at least two of the tuning ranges may be contiguous or may overlap with each other.

The tuner may comprise base band filtering for filtering output signals of the frequency changer arrangement. The baseband filtering may comprise low pass filtering. The low pass filtering may have a selectable cut-off frequency. The output of the baseband filtering may be connected to an analog/digital converter.

Each of the input stages may comprise a band limit filter for attenuating signals outside the tuning range.

Each of the input stages may comprise an automatic gain control circuit.

The at least one tracking filter of each of the input stages may comprise a bandpass filter. Each of the bandpass filters may comprise an image reject filter. Each of the bandpass filters may have a passband substantially equal to the width of each of the channels.

The at least one tracking filter of each of the input stages may comprise a local oscillator reject filter, such as a notch filter.

Each of the input stages may be arranged to be depowered when disabled.

The frequency changer arrangement may comprise a single frequency changer having an input connected to the output of the input stages. As an alternative, the frequency changer arrangement may comprise a respective frequency changer in each of the input stages. The or each frequency changer may be a quadrature frequency changer.

The or each frequency changer may have a mixer and a local oscillator whose frequency is above the frequency band containing the channels. The or each frequency changer may have a programmable frequency divider between the mixer and the local oscillator. The or each local oscillator may comprise a voltage controlled oscillator for receiving a control voltage and each of the tracking filters may have a voltage-dependent component for receiving the control voltage. As an alternative, the or each local oscillator may comprise a voltage controlled oscillator for receiving a control voltage and each of the tracking filters may have a voltage-dependent component for receiving the sum of the control voltage and a respective offset voltage.

Each of the tracking filters may have a voltage-dependent component connected to a digital/analog converter whose input is connected to a memory containing a look-up table and arranged to be addressed in accordance with channel selection.

The tuner may comprise an alignment controller for varying the value of a frequency-determining component of each of the tracking filters so as substantially to maximise the amplitude of a signal within the tuner resulting from a reference signal supplied to the radio frequency input.

It is thus possible to provide a tuner which avoids the need for external filtering while providing an acceptable performance, for example with digitally encoded signals. It is possible to embody such a tuner as a single monolithically integrated circuit to allow a reduction in size and cost. Relatively low power consumption can be achieved because the use of tracking filtering means that active stages such as mixers do not need to have a high quiescent current which would otherwise be necessary in order to provide acceptable performance when receiving higher signal levels of broadband signals. The use of zero intermediate frequency conversion also reduces the performance requirements of analog/digital conversion.

The present invention will be further described, by way of example, with reference to the accompanying drawings, in which:
Figure 1 is a block circuit diagram of a known type of tuner;
Figure 2 is a block schematic diagram of a tuner constituting a first embodiment of the invention;
Figure 3 is a block circuit diagram of a tuner constituting a second embodiment of the invention;
Figure 4 is a block circuit diagram of a tuner constituting a third embodiment of the invention;
Figure 5 is a block circuit diagram of a local oscillator arrangement for use in the tuners shown in Figures 2 to 4; and
Figure 6 is a block schematic diagram illustrating an arrangement for providing local oscillator and tracking filter control which may be used in place of the arrangements shown in the tuners of Figures 2 to 4.

Like reference numerals refer to like parts throughout the drawings.

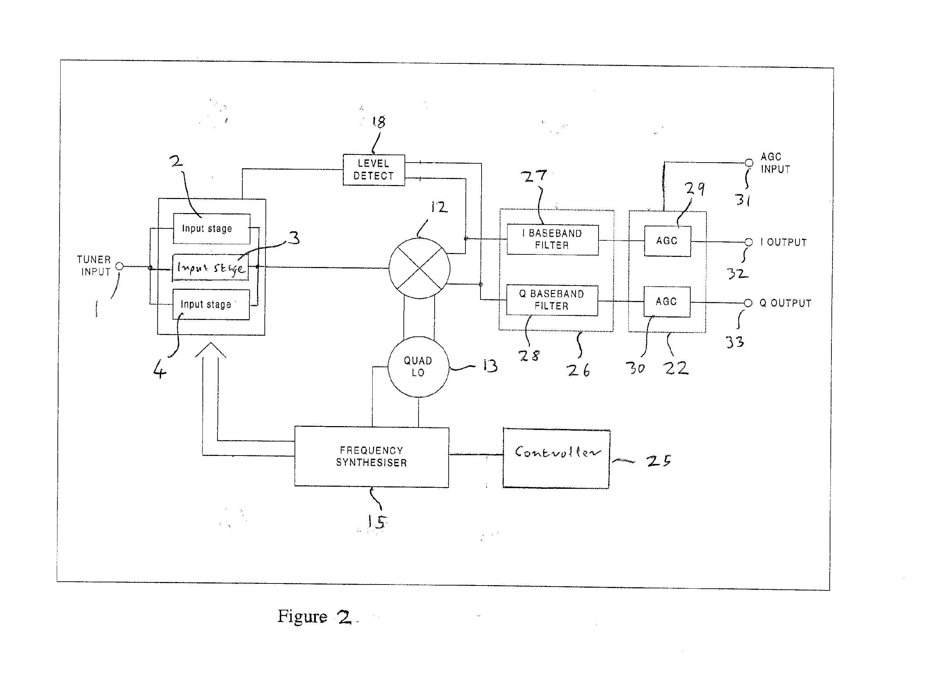

The tuner shown in Figure 2 is similar to that shown in Figure 1 in that it comprises three input stages 2 to 4, a mixer 12 and an oscillator 13 controlled by a frequency synthesiser 15, and an IF AGC arrangement 22. Each of the input stages 2 to 4 comprises a band limit filter, single tuned tracking filter, AGC circuit controlled by the level detector 18 and double tuned tracking filter as shown in Figure 1 and operating as described with reference to Figure 1. However, the input stages do not contain a frequency changer.

The outputs of the input stages are connected to a single frequency changer which comprises a quadrature mixer 12 and a quadrature oscillator 13. In practice, the quadrature mixer 12 may comprise two individual mixers which receive their input signals from the input stages 2 to 4 and the oscillator 13 may produce in-phase and quadrature output signals to the respective individual mixers. A controller 25 controls the operation of the tuner and, in particular, the operation of the frequency synthesiser 15 for selecting a channel for reception. The frequency synthesiser controls the quadrature local oscillator 13 in the well-known way and in addition supplies control signals to the input stages 2 to 4. The band limit filtering in the input stages 2 to 4 divides the input band into three sub-bands and the control signals from the frequency synthesiser 15 enable the input stage for the sub-band containing the channel which has been selected for reception by the controller 25. In particular, the frequency synthesiser 15 disables the other input stages by depowering them. The frequency synthesiser also supplies the appropriate control voltages to the tracking filters in the enabled input stage so as to pass the selected channel and so as to suppress the local oscillator frequency to prevent reradiation from the tuner input 1.

The frequency changer converts the selected channel to zero intermediate frequency and supplies baseband I and Q output signals. The local oscillator signals supplied to the individual mixers of the arrangement 12 have a frequency substantially equal to the centre frequency of the selected channel and the passband of the tracking filtering in the enabled input stage is similarly centred on the centre frequency of the selected channel. As described hereinafter, the local oscillator 13 comprises a voltage controlled oscillator and a programmable frequency divider and the local oscillator reject filtering provides a notch response at the frequency of the voltage controlled oscillator so that the selected channel is substantially unaffected by the local oscillator reject filtering.

The quadrature baseband outputs of the mixer arrangement 12 are supplied to a filtering arrangement 26 which comprises a baseband filter 27 for the in-phase signal I and a baseband filter 28 for the quadrature signal Q. Each of the baseband filters 27 and 28 comprises a low pass filter whose cut-off or turnover frequency can be selected in accordance with the channel bandwidth. For example, in the case of the DVB standard system where the channel bandwidth is 8MHz, the baseband filters 27 and 28 may have a cut-off frequency of 4.1MHz and may be sixth order Chebychev low pass filters.

The outputs of the filters are supplied to the AGC circuit 22, which comprises individual AGC stages 29 and 30 having an AGC input 31 for receiving a control signal from a digital demodulator (not shown). The output signals of the stages 29 and 30 are supplied to I and Q outputs 32 and 33 of the tuner for connection to the digital demodulator, which includes analog/digital conversion and performs all the functions associated with demodulation and error correction in the digital domain in accordance with the digital modulation standard of the selected channel. The cut-off frequency of the baseband filtering may be selected by a control signal from the demodulator or from the controller 25 so as to be appropriate to the channel bandwidth.

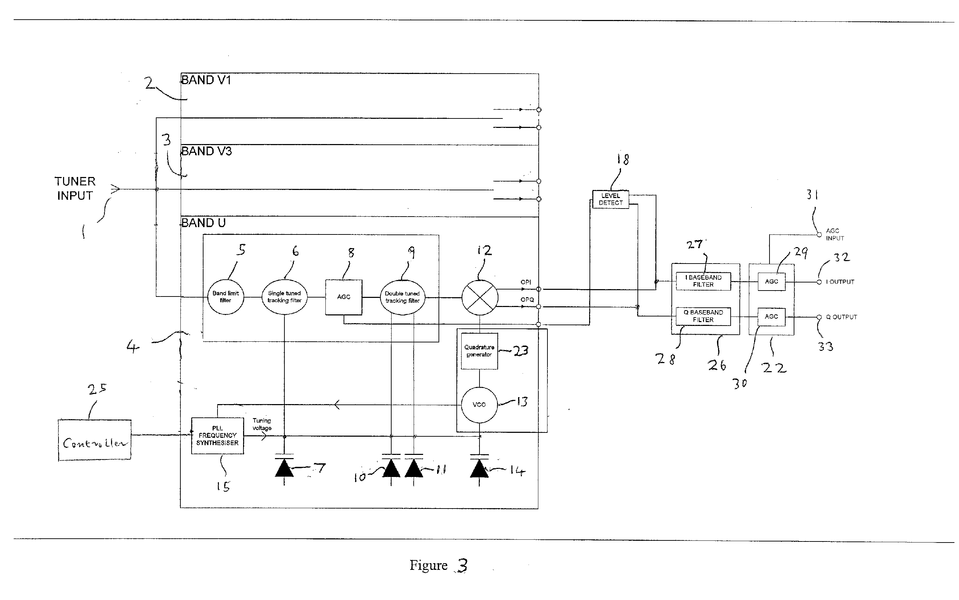

Figure 3 illustrates a tuner which differs principally from that shown in Figure 2 in that the single frequency changer arrangement common to all of the input stages 2 to 4 is replaced by an individual frequency changer at the output of each of the input stages 2 to 4. The circuit arrangements are identical for all of the input stages and only that of the stage 4 is shown in detail.

Figure 3 shows a voltage controlled oscillator 13 connected via a quadrature generator 23 to the quadrature mixing arrangement 12.

In the tuner of Figure 3, the tuning voltage generated by the synthesiser 15 is supplied not only to the oscillation frequency-determining variable capacitance diode 14 of the VCO 13 but also to the variable capacitance diodes 7, 10 and 11 of the tracking filters 6 and 9. During manufacture of the tuner, the tracking filters 6 and 9 are adjusted so that they track the frequency of the local oscillator signal supplied to the mixing arrangement 12 over the tuning range of the input stage. For example, the input stage 2 may have a tuning range from 50 to 160MHz, the input stage 3 may have a tuning range from 160 to 470MHz and the input stage 4 may have a tuning range from 470 to 860MHz. However, because the frequency changer is of the zero intermediate frequency type, there is no need for adjustment of the filters to offset their centre frequencies from the local oscillator frequency when the same voltage is applied, as is required in the known tuner shown in Figure 1.

In the tuner shown in Figure 3, the frequency of the local oscillator signal supplied to the mixer 12 is at the centre of the channel which has been selected for reception. The filter 6 therefore cannot be a notch filter tuned to the local oscillator frequency (as in the case of the tuner shown in Figure 1) but is a single-tuned bandpass filter centred on the frequency of the selected channel so as to provide further attenuation of out-of-band interfering signals. Alternatively, the filter 6 may comprise a tracking filter, such as a notch filter, tuned to provide attenuation of harmonics of the local oscillator frequency or to attenuate other interfering signals so as to prevent such signals being radiated from the tuner input 1 or from being otherwise received from the tuner or converted to base band by the mixer 12.

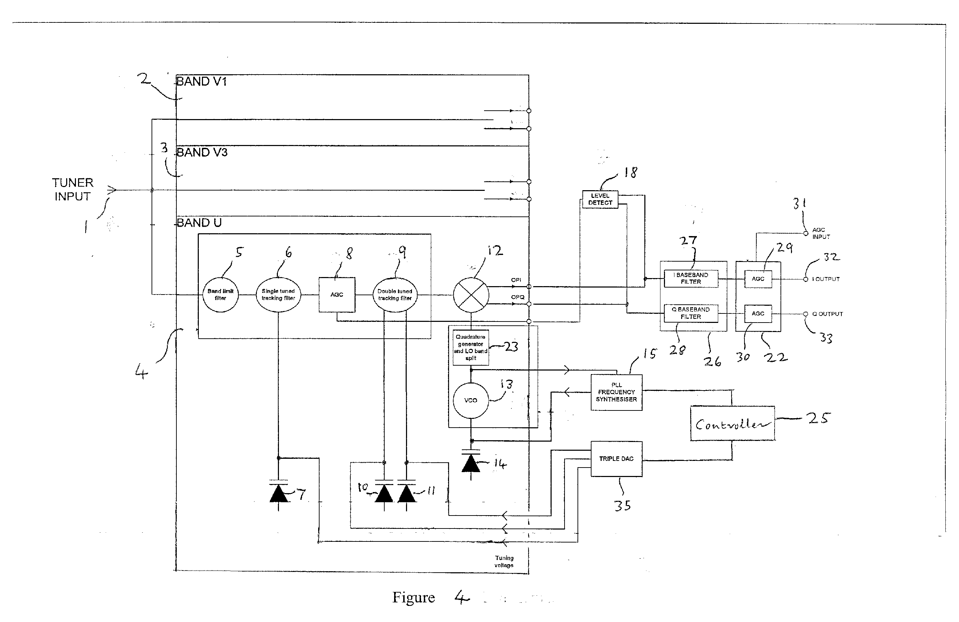

The tuner shown in Figure 4 differs from that shown in Figure 3 in the way the control voltages for the variable capacitance diodes 7, 10, 11 and 14 are generated. The control voltage for the diode 14 of the VCO 13 is generated in the usual way by the synthesiser 15 in accordance with the channel selection by the controller 25. However, the control voltages for the diodes 7, 10 and 11 are generated by a triple digital/analog converter (DAC) controlled by the controller 25. The output of each DAC is connected to the respective diode so that the diode voltages can be controlled independently. The digital inputs of the DACs are supplied by the controller 25, for example from a memory which contains look-up tables representing a function of the diode voltage against the channel selection. The look-up table may be created and stored in the controller 25 during an alignment phase of the manufacture of the tuner which ensures that the tracking filters are correctly aligned with the VCO 13. Each look-up table may have an entry for each channel. Alternatively, there may be look-up table entries for a limited number of the channels spread across the input band and the diode control voltages for channels without entries may be obtained by interpolation so as to reduce the memory requirements in the controller 25.

In an alternative arrangement, the circuit of Figure 4 may be modified such that the control voltage from the synthesiser 15 is supplied to the cathodes of all of the variable capacitance diodes 7, 10, 11 and 14 with the control voltages from the triple DAC 35 supplied as offset voltages referenced to ground to the anodes of the diodes 7, 10 and 11.

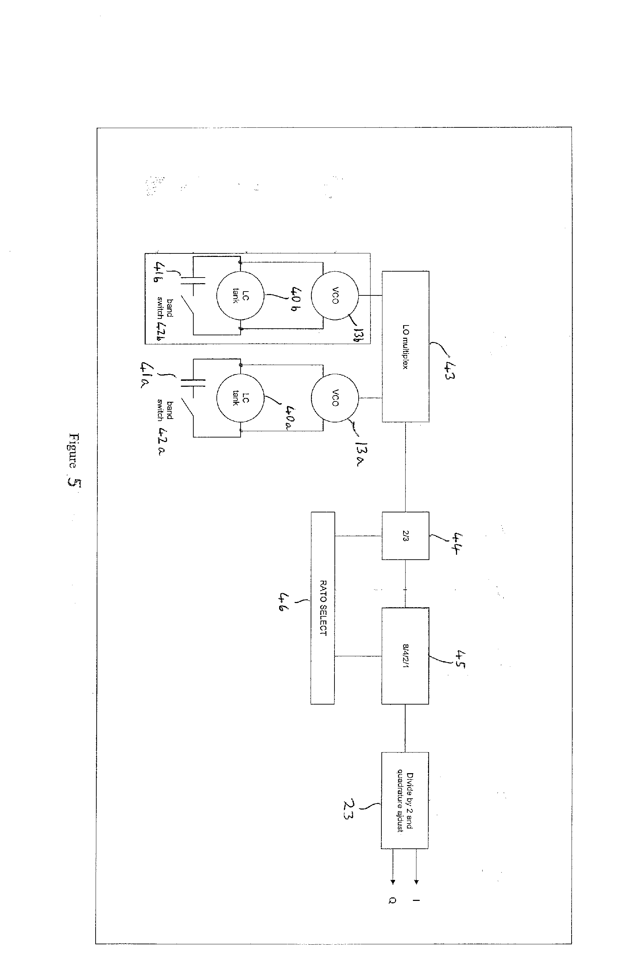

Figure 5 illustrates a local oscillator arrangement which may be used in any of the tuners shown in Figures 2 to 4. The arrangement comprises a plurality (two in the example shown) of voltage controlled oscillators 13a, 13b having oscillation frequency determining circuits 40a, 40b in the form of inductance/capacitance (LC) tank circuits. The tank circuits include voltage controlled capacitance characteristics for tuning the resonant frequency and hence the frequency of oscillation. In order to enhance the tuning range, each oscillator may have an additional element, shown as capacitors 41a, 41b, which may be switched in parallel or series with the resonant network of the tank circuit by electronic bandswitches 42a and 42b.

The VCO outputs are connected to a multiplexer 43 for selecting which oscillator is to be active. For example, the multiplexer 43 may comprise a summer and the or each non-selected oscillator may be depowered. The output of the multiplexer 43 is supplied to a programmable divider comprising a first divider 44 for selectively dividing the frequency of its input signal by 2 or 3 and a second divider 45 for selectively dividing the frequency of its input signal by 8, 4, 2 or 1. The total division ratio is controlled by a ratio select circuit 46. The output of the second divider 45 is supplied to the circuit 23, which performs a further divide by 2 and forms the quadrature local oscillator output signals I and Q.

The following table illustrates the frequency ranges which may be obtained from the local oscillator arrangement shown in Figure 5.

| VCO minimum frequency 2000 MHz | | | |
|---|---|---|---|
| VCO maximum frequency 4000 MHz | | | |
| prescaler ratio | quad ratio | minimum frequency | maximum freaquency |
| 2 | 2 | 500 | 1000 |
| 3 | 2 | 533 | 667 |
| 4 | 2 | 250 | 500 |
| 6 | 2 | 167 | 333 |
| 8 | 2 | 125 | 250 |
| 12 | 2 | 83 | 167 |
| 16 | 2 | 62.5 | 125 |
| 24 | 2 | 42 | 83 |

In this example, the frequency range of signals supplied to the programmable divider is from 2000 to 4000MHz. This range may be provided by a single VCO, a single VCO with bandswitching, or two or more VCOs each with or without bandswitching. The first column headed "prescaler ratio" illustrates the different frequency division ratios which may be provided by the dividers 44 and 45. The second column headed "quad ratio" illustrates the frequency division ratio by the circuit 23 which is always present. For each prescaler ratio, the minimum and maximum frequencies are illustrated in the next two columns of the table.

With such an arrangement, the VCO frequency is always above the highest frequency of the input band to the tuner and the local oscillator reject filter 6 in each of the input stages 2 to 4 tracks the VCO frequency so as to suppress leakage of the VCO signal to the tuner input, from which it may cause interference with other equipment, for example by reradiation from an aerial connected to the tuner input or directly through a cable distribution network to which the tuner input is connected. Also, leakage of the VCO output at such relatively high frequencies substantially avoids interference with reception of the selected channel.

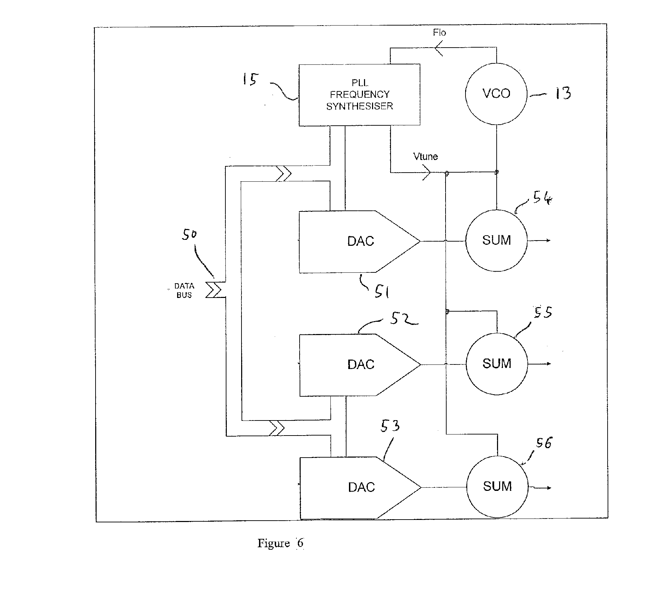

Figure 6 illustrates another technique for generating the control voltages for the variable capacitance diodes. The VCO 13 is controlled by the synthesiser 15 in the normal way, the synthesiser receiving control signals via a data bus 50 from the controller 25. The data bus is also connected to DACs 51, 52 and 53, whose outputs are connected to first inputs of summers 54, 55 and 56 respectively. The second inputs of the summers 54 to 56 receive the control voltage Vtune from the synthesiser 15 used to control the oscillation frequency Flo of the VCO 13.

As described hereinbefore, the controller 25 controls the synthesiser 15 such that the output frequency Flo of the VCO 13 is equal to the channel centre frequency of the channel which is selected for reception. The synthesiser 15 supplies a control voltage Vtune which is such as to phase-lock the VCO to the required frequency and this control voltage is supplied to the summers 54 to 56. The DACs 51 to 53 receive inputs from the controller 25 for generating offset voltages so that the output voltages of the summers 54 to 56 supplied to the variable capacitance diodes 7, 10 and 11 are such that the tracking filters correctly track the VCO frequency.

As described hereinbefore, the digital signals supplied to the DACs 51 to 53 may be derived from a look-up table generated during a manufacturing alignment operation. Alternatively, the controller 25 may be arranged to perform an alignment operation, for example each time the tuner is powered or each time the channel selection is changed. For example, a reference signal may be injected into the input of the tuner and the controller may supply digital codes so as to sweep the output voltage of each DAC in turn to locate the correct voltage for the respective diode, for example the voltage giving maximum signal amplitude after the frequency changer. Such an arrangement has the advantage that the effect of component values drifting with time may be substantially eliminated as the tuner is periodically realigned and this compensates for any component value changes. However, the performing of such a realigning operation takes time.

An alternative technique is a combination of the above described techniques such that an initial value is supplied from a look-up table and the alignment operation is then used to correct for any residual alignment errors. Because the initial value should be reasonably close to the desired value, the time required for the alignment operation can be substantially reduced.

## Claims

1. A tuner for converting any selected one of a plurality of radio frequency channels to an intermediate frequency, comprising: a radio frequency input (1) connected to the inputs of a plurality of input stages (2-4), each of which comprises at least one tracking filter (6, 9) having a passband which is tunable across a tuning range, the tuning ranges of the input stages (2-3) being different from each other, **characterised in that** the input stages (2-4) are arranged to be enabled one at a time and **characterised by** a frequency changer arrangement (12, 13, 14, 23) for converting the selected channel from the enabled one of the input stages (2-4) to substantially zero intermediate frequency.

2. A tuner as claimed in claim 1, **characterised in that** the radio frequency channels contain digitally modulated signals.

3. A tuner as claimed in claim 1 or 2, **characterised in that** adjacent ones of at least two of the tuning ranges are contiguous or overlap with each other.

4. A tuner as claimed in any one of the preceding claims, **characterised by** comprising baseband filtering (26-28) for filtering output signals of the frequency changer arrangement (12-14, 23).

5. A tuner as claimed in claim 4, **characterised in that** the baseband filtering comprises low pass filtering (26-28).

6. A tuner as claimed in claim 5, **characterised in that** the low pass filtering (26-28) has a selectable cut-off frequency.

7. A tuner as claimed in any one of claims 4 to 6, **characterised in that** the output of the baseband filtering (26-28) is connected to an analog/digital converter.

8. A tuner as claimed in any one of the preceding claims, **characterised in that** each of the input stages (2-4) comprises a band limit filter (5) for attenuating signals outside the tuning range.

9. A tuner as claimed in any one of the preceding claims, **characterised in that** each of the input stages (2-4) comprises an automatic gain control circuit (8).

10. A tuner as claimed in any one of the preceding claims, **characterised in that** the at least one tracking filter (6, 9) of each of the input stages (2-4) comprises a bandpass filter (9).

11. A tuner as claimed in claim 10, **characterised in that** each of the bandpass filters (9) comprises an image reject filter.

12. A tuner as claimed in claim 10 or 11, **characterised in that** each of the bandpass filters (9) has a passband substantially equal to the width of each of the channels.

13. A tuner as claimed in any one of the preceding claims, **characterised in that** the at least one tracking filter (6, 9) of each of the input stages comprises a local oscillator reject filter (6).

14. A tuner as claimed in any one of the preceding claims, **characterised in that** each of the input stages (2-4) is arranged to be depowered when disabled.

15. A tuner as claimed in any one of the preceding claims, **characterised in that** the frequency changer arrangement (12-14, 23) comprises a single frequency changer having an input connected to the outputs of the input stages (2-4).

16. A tuner as claimed in any one of claims 1 to 14, **characterised in that** the frequency changer arrangement (12-14, 23) comprises a respective frequency changer in each of the input stages (2-4).

17. A tuner as claimed in claim 15 or 16, **characterised in that** the or each frequency changer (12-14, 23) is a quadrature frequency changer.

18. A tuner as claimed in any one of claims 15 to 17, **characterised in that** the or each frequency changer (12-14, 23) has a mixer (12) and a local oscillator (13, 14, 23) whose frequency is above the frequency band containing the channels.

19. A tuner as claimed in claim 18, **characterised in that** the or each frequency changer (12-14, 23) has a programmable frequency divider (44-46) between the mixer (12) and the local oscillator (13a, 13b).

20. A tuner as claimed in claim 18 or 19, **characterised in that** the or each local oscillator comprises a voltage controlled oscillator (13) for receiving a control voltage and each of the tracking filters (6, 9) has a voltage-dependent component (7, 10, 11) for receiving the control voltage.

21. A tuner as claimed in claim 18 or 19, **characterised in that** the or each local oscillator comprises a voltage controlled oscillator (13) for receiving a control voltage and each of the tracking filters (6, 9) has a voltage-dependent component (7, 10, 11) for receiving the sum of the control voltage and a respective offset voltage.

22. A tuner as claimed in any one of claims 1 to 19, **characterised in that** each of the tracking filters (6, 9) has a voltage-dependent component (7, 10, 11) connected to a digital/analog converter (35, 51-53) whose input is connected to a memory (25) containing a look-up table and arranged to be addressed in accordance with channel selection.

23. A tuner as claimed in any one of claims 1 to 19, 21 and 22, comprising an alignment controller (25) for varying the value of a frequency-determining component (7, 10, 11) of each of the tracking filters (6, 9) so as substantially to maximise the amplitude of a signal within the tuner resulting from a reference signal supplied to the radio frequency input (1).
